# EUROPÄISCHE PATENTSCHRIFT

(11) **EP 2 695 298 B1**
(45) Veröffentlichungstag und Bekanntmachung des Hinweises auf die Patenterteilung: **08.05.2019**
(21) Anmeldenummer: 12708497.8
(22) Anmeldetag: 02.03.2012
(51) Int. Cl.: H03K 17/955, C03C 17/34

(54) **NÄHERUNGSSENSOR**
PROXIMITY SENSOR
CAPTEUR DE PROXIMITÉ

(30) Priorität: 01.04.2011 US 201161470571 P; 20.04.2011 DE 102011018364
(43) Veröffentlichungstag der Anmeldung: 12.02.2014
(73) Patentinhaber: Oerlikon Surface Solutions AG, Pfäffikon, 8808 Pfäffikon (CH)
(72) Erfinder: KECKES, Antal, 78244 Gottmadingen (DE); SCHULER, Peter, 72202 Nagold (DE); HERMANN, Thomas, 72510 Stetten a.k.M. (DE)
(74) Vertreter: Kempkens, Anke
(86) Internationale Anmeldenummer: PCT/EP2012/000927
(87) Internationale Veröffentlichungsnummer: WO 2012/130372

(56) Entgegenhaltungen:
- EP-A1- 2 233 840
- WO-A1-2010/084733

## Beschreibung

Die vorliegende Erfindung betrifft einen elektronischen Näherungssensor.

Elektronische Näherungssensor mit von aussen kapazitiv beeinflussbaren elektrischen oder elektronischen Schaltungen wie zum Beispiel Oszillatoren sind seit langem bekannt (vgl. DE 27 44 785). Generell gesprochen wird durch Annäherung eines Gegenstandes an die Oberfläche des Sensors die Kapazität zumindest eines Elementes der Schaltung verändert. Dies führt zu Änderungen im elektrischen Verhalten der Schaltung. Beispielsweise kann bei einem Schwingkreis die Frequenz verändert werden. Eine solche Frequenzänderung kann detektiert und als Schaltsignal interpretiert werden.

Das Dokument WO 2010/084733 A1 offenbart ein Dekorelement zur Übertragung von Radiowellen umfassend eine mit einer Halbleiterschicht (aus Silizium oder Germanium) und einer Polymerschicht beschichtete Dekorfläche.

Das Dokument EP 2 383 364 A1 offenbart einen Näherungsschalter einer Kochplatte umfassend eine Glassplatte, die mit einer Halbleiterschicht (aus Silizium oder Germanium) beschichtet ist.

Insbesondere im modernen Fahrzeugbau werden verstärkt multifunktionale Oberflächen eingesetzt, die auch als Sensorflächen verwendet werden können. Der Trend geht hierbei weg von klassischen Schaltern oder Tasten um Funktionen anzusteuern, hin zu direkt in die Kunststoffoberflächen integrierten Sensorelementen. Diese können, wie beispielhaft oben beschrieben, mit Hilfe kapazitiver Auswertung erkennen, ob ein Finger sich der Sensorfläche nähert und so Schaltfunktionen ausgeführt werden müssen. Die Technologie der Sensorabfrage ist hierbei gut bekannt und auch technisch entwickelt.

Die Sensorelemente liegen dabei unterhalb der Dekorflächen und können so recht einfach beispielsweise in die Kunststoffoberflächen eines Automobil-Interieurs integriert werden. Ein großes Problem ergibt sich derzeit aber dadurch, dass die Dekorflächen über den Sensor-aktiven Flächen zumeist ein metallisches Aussehen haben sollen.

Die Metallbeschichtung von Kunststoffoberflächen ist hier eine bekannte Technik, die aber den großen Nachteil hat, das metallische Beschichtungen in der Fläche leitfähig sind und somit unterhalb der Dekorfläche keine kapazitive Abtastung des Signals mehr erfolgen kann.

Das Problem stellt sich daher folgendermassen dar: Einerseits werden metallisch glänzende Kunststoffoberflächen gefordert, die aber andererseits die darunterliegenden kapazitiven Sensoren nicht abschirmen. Besondere Herausforderungen ergeben sich in der Problemstellung dadurch, dass die metallischen Oberflächen sowohl durch ihren Glanzgrad und als auch durch ihren Farbton (CIE-Lab Werte) gekennzeichnet sind.

Es ist daher die Aufgabe der vorliegenden Erfindung das oben geschilderte Problem zu überwinden oder zumindest abzuschwächen.

Die Erfindung ist durch die Ansprüche 1 und 4 definiert.

Erfindungsgemäss wird die Aufgabe dadurch gelöst, dass die Dekorfläche eines kapazitiven Näherungsschalters mit einer dünnen, zwischen 10nm und 100nm dicken Halbleiterschicht beschichtet wird. Besonders geeignet ist hierfür Silizium. Diese Beschichtung kann mittels physical vapor deposition (PVD) erfolgen. Dichte und damit bevorzugte Schichten können mittels eines Magnetron-Zerstäubungsverfahren (magnetron sputtering) erzielt werden.

Die Erfindung wird nun im Detail anhand von Beispielen genauer erläutert.

Gemäss einer ersten Ausführungsform der vorliegenden Erfindung wird eine 35nm dicke (d.h. im Dickenbereich von 10nm bis 100nm liegende) Silizumschicht als Halbleiterschicht auf die Oberfläche eines kapazitiven Näherungssensors aufgebracht. Um eventuelle Oberflächenstrukturen zu glätten wird auf die Oberfläche zunächst ein Primer (UV Acryl-Lack) aufgebracht. Nach dem Aufbringen der Si-Schicht mittels Magnetronzerstäuben wird im vorliegenden Beispiel eine Deckschicht (UV Acryl-Lack) zum zusätzlichen Schutz der dünnen Si-Schicht aufgebracht. Es resultiert eine bläulich bis gelblich metallisch schimmernde Oberfläche. Aufgrund der geringen elektrischen Leitfähigkeit von Silizium wird der Sensor nicht elektrisch bzw. kapazitiv abgeschirmt.

Gemäss einem Beispiel wird die Halbleiterschicht als Schichtsystem ausgeführt. Dies kann zum Beispiel als Wechselschichtsystem mit einem Halbleiter, z.B. Si und einem Dielektrikum z.B. SiO₂ aufgebaut werden. Die Gesamtdicke der Si-Schichten sollte dabei wiederum im Bereich zwischen 10nm und 100nm liegen. Um die gewünschte Transmissions- und Reflexionscharakteristik im sichtbaren Bereich des Spektrums elektromagnetischer Strahlen zu erhalten, stehen heute dem Fachmann leistungsstarke Optimierungsprogramme für optische Dünnfilme zur Verfügung. Auf eine tiefer gehende diesbezügliche Ausführung wird daher vorliegend verzichtet.

Gemäss einer weiteren Ausführungsform der vorliegenden Erfindung wird für die Beschichtung als Halbleitermaterial Germanium verwendet. Auch diese Beschichtung kann als einzelne dünne Monolayer mit einer Dicke 10nm bis 100nm oder als Wechselschichtsystem mit einem oder mehreren Dielektrika, wie zum Beispiel SiO₂ ausgeführt sein. Insbesondere kann Ge auch mit Si kombiniert werden, um die gewünschten Effekte zu erzielen.

Die vorgenannten Ausführungsformen sind vorliegend mit Primer beschrieben. Eine solche Lackschicht, welche zwischen der PVD-Schicht und dem Substrat angeordnet ist kann als Basecoat bezeichnet werden. Gegebenenfalls kann auf dieses Base-Coat verzichtet werden.

Es wurde ein elektronischer Näherungssensor mit unter einer Dekorfläche angeordnetem Sensorelement beschrieben dessen Dekorfläche mit einer dünnen Halbleiterschicht beschichtet ist. Als Halbleiterschicht wird in diesem Zusammenhang eine zumindest einen Halbleiter umfassende Schicht bezeichnet. Die Dicke der Halbleiterschicht beträgt zwischen 10nm und 100nm. Vorzugsweise umfasst die Halbleiterschicht Silizium als Halbleitermaterial. Besonders bevorzug besteht die Halbleiterschicht aus Silizium.

Die Halbleiterschicht kann Bestandteil eines zumindest eine weitere Schicht umfassenden Schichtsystems sein, welches vorzugsweise ein Interferenzschichtsystem ist. Die zumindest eine weitere Schicht kann eine SiO₂-Schicht sein. Vorzugsweise handelt es sich bei dem Schichtsystem um ein Wechselschichtsystem. Zwischen dem die Dekorfläche bildenden Körper und der Halbleiterschicht ist erfindungsgemäß eine Zwischenschicht vorgesehen, die eine Polymerschicht umfasst, welche aus einem UV-gehärteten Lack besteht. Die gegen die Umgebung abschliessende Schicht kann eine Polymerschicht vorgesehen sein, welche vorzugsweise aus einem UV-gehärteten Lack besteht. Der elektronische Näherungssensor bildet einen Näherungsschalter.

Es wurde ein Verfahren zur Herstellung des vorgenannten elektronischen Näherungssensors beschrieben mit den Schritten:
- Bereitstellen des elektronischen Näherungssensors mit der Dekorfläche
- Beschichten der Dekorfläche mit einer Halbleiterschicht deren Schichtdicke zwischen 10nm und 100nm liegt, wobei das Beschichten mittels eines Vakuumprozesses erreicht wird. Der Vakuumprozess ist vorzugsweise ein PVD und/oder ein CVD-Prozess.

## Patentansprüche

1. Elektronischer Näherungssensor mit unter einer Dekorfläche angeordnetem Sensorelement, wobei der elektronische Näherungssensor einen kapazitiven Näherungsschalters umfasst, welcher die Dekorfläche aufweist, wobei die Dekorfläche mit einer dünnen Halbleiterschicht beschichtet ist, wobei die Halbleiterschicht eine Schicht aus Silizium oder Germanium aufweist, wobei die Halbleiterschicht als einzelne dünne Monolayer mit einer Dicke zwischen 10 nm und 100 nm ausgeführt ist, **dadurch gekennzeichnet, dass** zwischen dem Dekorfläche bildenden Körper und der Halbleiterschicht eine Zwischenschicht vorgesehen ist, die eine Polymerschicht umfasst, welche aus einem UV-gehärteten Lack, vorzugsweise eine UV Acryl-Lack, besteht und eventuelle Oberflächenstrukturen der Dekorfläche glättet.

2. Elektronischer Näherungssensor nach Anspruch 1, **dadurch gekennzeichnet, dass** als gegen die Umgebung abschliessende Schicht eine Polymerschicht vorgesehen ist, welche aus einem UV-gehärteten Lack, vorzugsweise eine UV Acryl-Lack, besteht und die Halbleiterschicht schützt.

3. Automobil-Interieurs mit einer Kunststoffoberfläche und einem in der Kunststoffoberfläche integrierten elektronischen Näherungssensor nach einem der vorangehenden Ansprüche 1 oder 2.

4. Verfahren zur Herstellung eines elektronischen Näherungssensors nach einem der vorangehenden Ansprüche, wobei das Verfahren folgende Schritte umfasst:
- Bereitstellen des elektronischen Näherungssensors mit der Dekorfläche und dem unter der Dekorfläche angeordneten Sensorelement, wobei der elektronische Näherungssensor den kapazitiven Näherungsschalter umfasst, welcher die Dekorfläche aufweist, und
- Beschichten der Dekorfläche mit der Halbleiterschicht, welche eine Schicht aus Si oder Ge aufweist, wobei das Beschichten mittels eines Vakuumprozesses erreicht wird.

5. Verfahren nach Anspruch 4, **dadurch gekennzeichnet, dass** der Vakuumprozess ein PVD und/oder ein CVD-Prozess ist.

6. Verfahren nach Anspruch 5, **dadurch gekennzeichnet, dass** vor dem Beschichten der Dekorfläche mit der Halbleiterschicht einen ersten Lack auf die Dekorfläche aufgebracht wird und somit eventuelle Oberflächenstrukturen der zu beschichtenden Oberfläche geglättet werden, und anschliessend die Halbleiterschicht auf die so lackierte Oberfläche aufgebracht wird.

7. Verfahren nach Anspruch 6, **dadurch gekennzeichnet, dass** ein zweiter Lack als Deckschicht auf die Halbleiterschicht aufgebracht wird und somit die Halbleiterschicht geschützt wird.

## Claims

1. Electronic proximity sensor with a sensor element placed below a decorative surface, wherein the electronic proximity sensor comprises a capacitive proximity switch which has the decorative surface, wherein the decorative surface is coated with a thin semiconductor layer, wherein the semiconductor layer comprises a layer consisting of silicon or germanium, wherein the semiconductor layer is executed as an individual thin monolayer with a thickness of 10nm to 100nm, **characterized in that** between the component forming the decorative surface and the semiconductor layer an intermediary layer is provided which comprises the polymer layer which consists of a UV hardened lacquer, preferably a UV acrylic lacquer, and smooths potential surface structures of the decorative surface.

2. Electronic proximity sensor according to claim 1 **characterized in that** as a sealing layer against the environment a polymer coating is provided which consists of a UV-hardened lacquer, preferably a UV acrylic lacquer, and which protects the semiconductor layer.

3. Automobile interiors with a synthetic surface and an electronic proximity sensor integrated in the synthetic surface according to one of the preceding claims 1 or 2.

4. Method for producing an electronic proximity sensor according to one of the preceding claims, wherein the method comprises the following steps:
- providing the electronic proximity sensor having the decorative surface and the sensor element placed below the decorative surface, wherein the electronic proximity sensor comprises the capacitive proximity sensor that has the decorative surface, and
- coating the decorative surface with a semiconductor layer which comprises a layer consisting of Si or Ge, wherein the coating is achieved by means of a vacuum process.

5. Method according to claim 4 **characterized in that** the vacuum process is a PVD and/or a CVD process.

6. Method according to claim 5 **characterized in that** before coating the decorative surface with the semiconductor layer a first lacquer is applied onto the decorative surface and thus potential surface structures of the surface to be coated are smoothed, and then the semiconductor layer is applied onto the surface lacquered in this way.

7. Method according to claim 6 **characterized in that** a second lacquer as a top layer is applied onto the semiconductor layer and thus the semiconductor layer will be protected.

## Revendications

1. Capteur de proximité électronique ayant un élément détecteur placé au-dessous d'une surface décorative, le capteur de proximité électronique comprenant un détecteur de proximité capacitif qui a la surface décorative,
la surface décorative étant revêtue d'une mince couche semi-conductrice, la couche semi-conductrice ayant une couche consistant de silicium ou de germanium, la couche semi-conductrice étant exécutée comme mince mono-couche individuelle avec une épaisseur comprise entre 10nm et 100nm, **caractérisée en ce qu'**une couche intérmediare est prévue entre le corps formant la surface décorative et la couche semi-conductrice, quelle couche intermédiare comprend une couche polymère qui consiste d'un vernis durci aux UV, de préférence un vernis acrylique UV et qui lisse d'éventuelles structures de surface de la surface décorative.

2. Capteur de proximité électronique selon la revendication 1 **caractérisé en ce qu'**une couche polymère est prévue comme couche protectrice par rapport au milieu ambiant, quelle couche polymère consiste d'un vernis durci aux UV, de préférence un vernis acrylique UV, et qui protège la couche semi-conductrice.

3. Des intérieurs d'automobiles ayant une surface de matière plastique et un capteur de proximité électronique intégré dans la surface de matière plastique selon l'une des revendications précédentes 1 ou 2.

4. Procédé de fabrication d'un capteur de proximité électronique selon l'une des revendications précédentes, le procédé comprenant les étapes suivantes:
- fournir le capteur de proximité électronique avec la surface décorative et l'élément détecteur placé au-dessous de la surface décorative, le capteur de proximité électronique comprenant le détecteur de proximité capacitif qui a la surface décorative, et
- revêtir la surface décorative avec la couche semi-conductrice qui a une couche consistant de Si ou de Ge, le revêtement étant exécuté au moyen d'un procédé sous vide.

5. Procédé selon la revendication 4 **caractérisé en ce que** le processus sous vide est un processus PVD et/ou un processus CVD.

6. Procédé selon la revendication 5 **caractérisé en ce qu'**avant le revêtement de la surface décorative avec la couche semi-conductrice un premier vernis est appliqué sur la surface décorative et ainsi d'éventuelles structures de surface de la surface à revêtir sont lissées, et ensuite la couche semi-conductrice est appliquée sur la surface vernie de telle manière.

7. Procédé selon la revendication 6 **caractérisé en ce qu'**un second vernis est appliqué comme couche supérieure sur la couche semi-conductrice et ainsi la couche semi-conductrice est protégée.
